# EUROPÄISCHE PATENTSCHRIFT

(11) **EP 3 194 838 B1**
(45) Veröffentlichungstag und Bekanntmachung des Hinweises auf die Patenterteilung: **19.06.2019**
(21) Anmeldenummer: 15767451.6
(22) Anmeldetag: 11.09.2015
(51) Int. Cl.: F21S 41/20, F21S 41/663, F21S 41/16, F21S 41/14, F21S 41/63, G02B 26/10, G06K 15/12, G02B 27/42, G03B 21/00, G02B 26/08, H01S 5/00, H01S 5/40

(54) **SCHEINWERFER MIT EINEM LICHTUMLENKELEMENT**
HEADLAMP WITH A LIGHT DEFLECTING ELEMENT
PROJECTEUR AUTOMOBILE AVEC UN ÉLÉMENT DE DÉVIATION DE LUMIÈRE

(30) Priorität: 19.09.2014 DE 102014218957
(43) Veröffentlichungstag der Anmeldung: 26.07.2017
(73) Patentinhaber: Automotive Lighting Reutlingen GmbH, 72762 Reutlingen (DE)
(72) Erfinder: KNITTEL, Joachim, 72762 Reutlingen (DE); ROSENHAHN, Ernst-Olaf, 72411 Bodelshausen (DE)
(74) Vertreter: DREISS Patentanwälte PartG mbB
(86) Internationale Anmeldenummer: PCT/EP2015/070846
(87) Internationale Veröffentlichungsnummer: WO 2016/041862

(56) Entgegenhaltungen:
- EP-A1- 2 719 942
- AT-A1- 513 909
- DE-A1- 10 344 172
- DE-A1-102005 043 594
- JP-A- H03 228 011
- US-A- 2 222 937
- US-A- 4 822 974
- US-A1- 2004 036 934
- US-A1- 2013 334 424

## Beschreibung

Die vorliegende Erfindung betrifft einen Scheinwerfer nach dem Oberbegriff des Anspruchs 1. Ein solcher Scheinwerfer ist aus der AT 513909 A1 bekannt.

Ein solcher Scheinwerfer weist ein im Folgenden auch als Scanner bezeichnetes Lichtumlenkelement auf. Mit einem solchen Scanner können zum Beispiel Scheinwerfer gebaut werden, die nahezu jede beliebige Lichtverteilung erzeugen können. Dies ermöglicht eine dynamische Anpassung einer vom Scheinwerfer erzeugten Lichtverteilung an veränderliche Verkehrsbedingungen.

Dazu nimmt zum Beispiel eine im Kraftfahrzeug installierte Kamera die Verkehrssituation vor dem Fahrzeug auf. Eine Software analysiert die Bilder und steuert das Lichtumlenkelement und damit die Lichtverteilung so, dass die Fahrbahn immer optimal ausgeleuchtet ist und eine Blendung des Gegenverkehrs vermieden wird. Dadurch wird insbesondere die Sicherheit bei Nachtfahrten erhöht.

Ein mit einem solchen Scanner ausgestatteter Scheinwerfer ist zum Beispiel aus der DE 10 2007 055 480 B3 bekannt. Bei dem bekannten Gegenstand wird ein fokussierter Laserstrahl eines Lasers, der blaues Licht emittiert, mit Hilfe eines Scanners über ein Leuchtmittel (z.B. einen Phosphor) bewegt, welches das blaue Licht des Lasers durch Mischung mit gelbem oder gelb-rotem Fluoreszenzlicht in weißes Mischlicht umwandelt. Das weiße Licht wird über eine Optik auf die Fahrbahn gerichtet. Durch Bewegen des Lichtflecks des fokussierten Laserstrahls auf dem Leuchtmittel und gleichzeitiges Modulieren der Laserleistung können beliebige Lichtverteilungen erzeugt werden.

Aus der EP 0 291 475 A2 ist ein Scheinwerfer bekannt, der einen winkelbeweglichen Reflektor aufweist, der einen schmalen Strahl sehr schnell in unterschiedliche Raumrichtungen umlenkt. Als Folge werden kleine Bereiche im Takt der Richtungsänderungen des Strahles sequentiell beleuchtet und damit mit Licht abgetastet und damit gescannt. Die Gesamtfläche, die sich als Vereinigung der sequentiell abtastend beleuchteten kleinen Bereiche ergibt, stellt sich für den menschlichen Sehsinn bei hinreichend schneller Abtastung und periodisch ausreichend schnell wiederholter Abtastsequenz als zusammenhängende, helle Fläche und damit als eine zusammenhängende Lichtverteilung dar. Eine hinreichend schnelle Abtastung ergibt sich zum Beispiel dann, wenn die Abtastsequenz mit einer Frequenz wiederholt wird, die größer als 100 Hz ist.

Die bekannten Scheinwerfer arbeiten mit zwischen dem Laser und dem Leuchtmittel angeordneten und das Licht des Lasers periodisch auf verschiedene Bereiche des Leuchtmittels richtenden Lichtumlenkelementen, bei denen die Lichtumlenkung durch Reflexion erfolgt. Dies erfordert eine hohe Genauigkeit der Justierung der Reflektoren und der Rauigkeit der optischen Flächen der Reflektoren.

Von dem eingangs genannten bekannten Scheinwerfer unterscheidet sich der erfindungsgemäße Scheinwerfer durch die kennzeichnenden Merkmale des Anspruchs 1.

Der erfindungsgemäße Scheinwerfer besitzt damit die eingangs genannten Merkmale des Oberbegriffs des Anspruchs 1 und zeichnet sich ferner dadurch aus, dass er mehrere Laserlichtquellen aufweist, die übereinander angeordnet sind und von denen jede in einer Lichtverteilung, die sich im Vorfeld des Scheinwerfers einstellt, eine horizontale Lichtzeile erzeugt, dass das Lichtumlenkelement einen drehbar im Scheinwerfer gelagerten transparenten Festkörper und einen zur Drehung des transparenten Festkörpers eingerichteten Drehantrieb aufweist, wobei der transparente Festkörper wenigstens zwei Teilvolumina mit unterschiedlicher Brechzahl aufweist, die durch wenigstens eine lichtbrechende Grenzfläche voneinander getrennt sind, wobei der transparente Festkörper so angeordnet ist, dass sich die lichtbrechende Grenzfläche bei der Drehung des transparenten Festkörpers in dem Lichtweg befindet und dass sich ihre Drehwinkelposition relativ zu dem einfallenden Laserlicht bei einer Drehung des Festkörpers verändert.

Ein großer Vorteil der Erfindung liegt darin, dass das mit Transmission an Stelle von Reflexion arbeitende Lichtumlenkelement der vorliegenden Erfindung kostengünstiger und vor allem deutlich robuster ist als die bekannten Reflektorlösungen.

Ein weiterer Vorteil liegt darin, dass das Lichtumlenkelement aufgrund seiner Verwirklichung als transparenter Festkörper eine so große Masse und, damit einhergehend, eine so große Wärmekapazität aufweist, dass es eine für Kraftfahrzeugscheinwerfer erforderliche Laserleistung von bis zu 10 Watt verträgt und das dabei, trotz seiner Masse gleichzeitig eine kompakte Bauweise erlaubt, was sich aus dem hohen spezifischen Gewicht ergibt. Die Masse und das spezifische Gewicht sind dabei insbesondere im Vergleich zu Hohlspiegelreflektorlösungen groß.

Das Lichtumlenkelement hat aufgrund seiner mit Lichtbrechung an Stelle von Reflexion arbeitenden Umlenkung den weiteren Vorteil einer im Vergleich zu den bekannten, mit Reflexion arbeitenden Lichtumlenkelementen größeren mechanischen Toleranz bezüglich der Justierung und Rauigkeit der umlenkenden optischen Oberflächen.

Eine bevorzugte Ausgestaltung zeichnet sich dadurch aus, dass der transparente Festkörper eine für das Laserlicht transparente rotierbare Walze 1.

Bevorzugt ist auch, dass die Walze zwei Teilvolumina aufweist, von denen ein erstes Teilvolumen aus einem ersten Material besteht, das einen ersten Brechungsindex besitzt, und das zweite Teilvolumen aus einem zweiten Material besteht, das einen zweiten Brechungsindex besitzt, wobei der erste Brechungsindex von dem zweiten Brechungsindex verschieden ist.

Ferner ist bevorzugt, dass die Oberfläche der Walze als fokussierende Linse ausgestaltet ist.

Eine nicht erfindungsgemäße Ausgestaltung zeichnet sich dadurch aus, dass die Walze eine Zylinderform mit einem zur Zylinderachse senkrechten kreisförmigen Querschnitt aufweist.

Bevorzugt ist auch, dass die Walze eine Kugelform aufweist.

Ferner ist bevorzugt, dass die Walze eine Freiform aufweist.

Eine bevorzugte Ausgestaltung zeichnet sich dadurch aus, dass die lichtbrechende innere Grenzfläche eine Grenzfläche ist, welche beide Teilvolumina begrenzt, so dass sich die beiden Teilvolumina in der Grenzfläche berühren.

Bevorzugt ist auch, dass sich zwischen beiden Teilvolumina ein Luftspalt oder ein mit Material einer Brechzahl n3 ungleich n2 ungleich n1 gefüllter Spalt zwischen den beiden Teilvolumina befindet.

Ferner ist bevorzugt, dass die innere lichtbrechende Grenzfläche eine ebene Grenzfläche ist.

Eine bevorzugte Ausgestaltung zeichnet sich dadurch aus, dass die Drehachse in der inneren lichtbrechenden Grenzfläche liegt.

Bevorzugt ist auch, dass die innere lichtbrechende Grenzfläche eine Freiformfläche ist.

Ferner ist bevorzugt, dass das Lichtumlenkelement einen drehbar im Scheinwerfer gelagerten transparenten Festkörper und einen zur Drehung des transparenten Festkörpers eingerichteten Drehantrieb aufweist, wobei der transparente Festkörper wenigstens zwei Teilvolumina mit unterschiedlicher Brechzahl aufweist, die durch wenigstens eine lichtbrechende Grenzfläche voneinander getrennt sind, wobei der transparente Festkörper so angeordnet ist, dass sich die lichtbrechende Grenzfläche bei der Drehung des transparenten Festkörpers in dem Lichtweg befindet und dass sich ihre Drehwinkelposition relativ zu dem einfallenden Laserlicht bei einer Drehung des Festkörpers verändert.

Weitere Vorteile ergeben sich aus der nachfolgenden Beschreibung, den Zeichnungen und den Unteransprüchen.

Ausführungsbeispiele sind in den Zeichnungen dargestellt und werden in der nachfolgenden Beschreibung näher erläutert.

Dabei zeigen, jeweils in schematischer Form:
Figur 1 ein Ausführungsbeispiel eines Lichtumlenkelements in einem erfindungsgemäßen Laserscheinwerfer;
Figur 2 eine Seitenansicht des Umlenkelements mit drehbar gelagertem transparenten Festkörper;
Figur 3 eine Ablenkung eines Laserstrahls als Funktion des Drehwinkels für eine Ausgestaltung eines Lichtumlenkelements;
Figur 4 Ausgestaltungen, die sich in Form des jeweils rotierenden transparenten Festkörpers unterscheiden,
Figur 5 einen rotierbaren transparenten Festkörper mit einem Luftspalt;
Figur 6 ein Ausführungsbeispiel, bei dem mehrere Laserlichtquellen übereinander angeordnet sind; und
Figur 7 ein weiteres Ausführungsbeispiel, bei dem zwei Lichtumlenkelemente im Lichtweg hintereinander angeordnet sind.

Bei dieser Darstellung entspricht die x-Richtung der Hauptabstrahlrichtung des Scheinwerfers, die bei einer bestimmungsgemäßen Verwendung des Scheinwerfers in einem Kraftfahrzeug nach vorne gerichtet ist. Die y-Richtung liegt bei der bestimmungsgemäßen Verwendung parallel zur Querachse des Fahrzeugs, und die z-Richtung liegt bei der bestimmungsgemäßen Verwendung parallel zur Hochachse des Fahrzeugs.

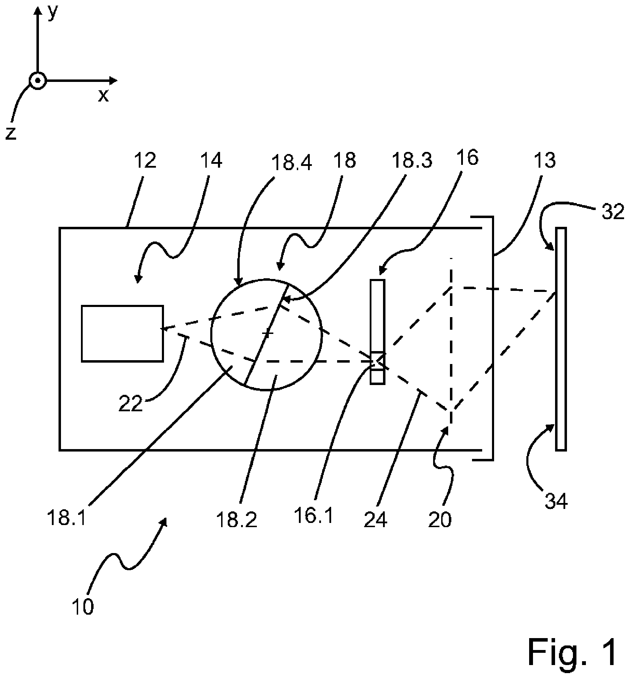

Die schematische Darstellung der Figur 1 bietet sich einem Betrachter, der von oben auf den parallel zur x-y-Ebene aufgeschnittenen Scheinwerfer blickt.

Der Laserscheinwerfer 10 weist ein Gehäuse 12 auf. Eine Lichtaustrittsöffnung des Gehäuses wird von einer transparenten Abdeckscheibe 13 abgedeckt. In dem Gehäuse befindet sich wenigstens ein Laser 14, ein Leuchtmittel 16 und ein in einem Lichtweg zwischen dem Laser und dem Leuchtmittel angeordnetes Lichtumlenkelement 18 sowie eine Projektionsoptik 20. Diese Elemente 14, 16, 18, 20 bilden zusammen ein Lichtmodul, das starr oder beweglich (zum Beispiel mechanisch schwenkbar) in dem Gehäuse angeordnet ist. Das Lichtmodul kann weitere Elemente wie einen oder mehrere strahlformende Spiegel und/oder Blende(n) aufweisen. Neben einem solchen Lichtmodul können weitere Lichtmodule in dem Gehäuse angeordnet sein, die andere Lichtfunktionen erfüllen, zum Beispiel Signallichtfunktionen wie ein Tagfahrlicht oder ein Blinklicht. Die Projektionsoptik kann ein optisches Element oder mehrere optische Elemente aufweisen. Als optisches Element kommt ein Reflektor, eine Linse oder eine katadioptrische Optik in Frage. Wenn die Optik mehrere optische Elemente aufweist, kann sie aus gleichartigen optischen Elementen oder auch aus verschiedenartigen optischen Elementen zusammengesetzt sein.

In Verbindung mit dieser Anordnung ist das Lichtumlenkelement 18 durch seine Beschaffenheit dazu eingerichtet, Licht des Lasers 14 periodisch auf verschiedene Bereiche des Leuchtmittels 16 zu richten.

Das Leuchtmittel 16 reagiert auf einfallendes Laserlicht 22 mit einer Emission von Fluoreszenzlicht, das sich mit dem Laserlicht 22 zu weißem Licht 24 mischt.

Die Projektionsoptik 20 ist im Lichtweg von Licht 24 angeordnet, das von dem Leuchtmittel 16 ausgeht. Die Projektionsoptik 29 ist dazu eingerichtet, vom Leuchtmittel ausgehendes Licht in ein vor dem Scheinwerfer 10 liegendes Vorfeld zu richten.

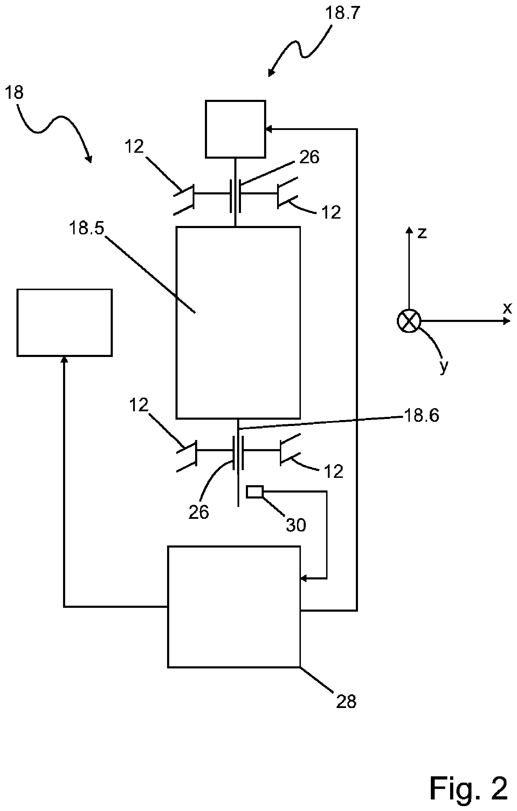

Das Lichtumlenkelement 18 weist einen drehbar im Scheinwerfer 10 gelagerten transparenten Festkörper und einen zur Drehung des transparenten Festkörpers eingerichteten Drehantrieb auf. Einzelheiten dazu werden weiter unten mit Bezug auf die Figur 2 erläutert.

Die Figur 1 zeigt darüber hinaus, dass der dort verwendete transparente Festkörper des Lichtumlenkelements 18 zwei Teilvolumina 18.1, 18.2 mit unterschiedlicher Brechzahl aufweist.

Beim Gegenstand der Figur 1 sind dies ein erstes Teilvolumen 18.1, das aus Material mit einem ersten Brechungsindex n1 besteht, und ein zweites Teilvolumen 18.2, das aus Material mit einem zweiten Brechungsindex n2 besteht. Die Brechzahl n1 des ersten Teilvolumens 18.1 beträgt zum Beispiel n1 = 1,2, und die Brechzahl n2 des zweiten Teilvolumens 18.2 beträgt zum Beispiel n2 = 1,4.

Die Teilvolumina sind durch wenigstens eine lichtbrechende innere Grenzfläche 18.3 voneinander getrennt. Außer der lichtbrechenden inneren Grenzfläche 18.3 weist der transparente Festkörper insbesondere eine äußere Lichteintrittsfläche 18.4 auf, die bevorzugt gekrümmt ist und in Verbindung mit ihrer lichtbrechenden Wirkung eine Linsenwirkung des transparenten Festkörpers begründet.

In der dargestellten Ausgestaltung ist die innere Grenzfläche 18.3 eine Grenzfläche, welche beide Teilvolumina begrenzt, so dass sich die beiden Teilvolumina 18.1, 18.2 in der Grenzfläche 18.3 berühren. In anderen Ausgestaltungen kann ein Luftspalt oder ein mit Material einer Brechzahl n3 ungleich n2 ungleich n1 zwischen den beiden Teilvolumina liegen.

Der transparente Festkörper ist in dem Lichtweg des vom Laser ausgehenden Lichtes 22 so angeordnet, dass sich die lichtbrechende Grenzfläche 18.3 des transparenten Festkörpers bei der Drehung des transparenten Festkörpers in dem genannten Lichtweg befindet und dass sich die Drehwinkelposition der lichtbrechenden Grenzfläche 18.3 relativ zu dem einfallenden Laserlicht 22 bei einer Drehung des Festkörpers verändert.

Fig. 2 zeigt eine Seitenansicht des Umlenkelements 18 in einer x-z-Ebene. Im Einzelnen zeigt die Figur 2 den transparenten Festkörper 18.5, der in Drehlagern 26 drehbar gelagert ist. Die Drehlager sind entweder mit dem Gehäuse 12 des Scheinwerfers oder mit einem Rahmen eines im Scheinwerfer starr oder beweglich angeordneten Lichtmoduls verbunden. Eine Drehachse 18.6 oder Welle des transparenten Festkörpers 18.5 ist mit einem Drehantrieb 18.7 verbunden. Der Drehantrieb ist bevorzugt ein Elektromotor, der die Welle direkt oder über ein Getriebe antreibt. Das Umlenkelement 18 weist damit insbesondere die Elemente 18.1 bis 18.7 auf. Der Elektromotor wird von einem Steuergerät 28 gesteuert, das dazu Eingangssignale von Signalgebern 30 empfängt. In der Figur 2 ist ein Signalgeber 30 stellvertretend für sämtliche in Frage kommenden Signalgeber dargestellt. Der dargestellte Signalgeber erfasst die Drehwinkelposition des Umlenkelements 30 relativ Richtung des einfallenden Laserlichts. Als alternative oder ergänzende Signalgeber kommen insbesondere Fahrerwunschsignalgeber, beispielsweise ein Lichtschalter in Frage. In Frage kommen ferner Helligkeitssensoren, welche eine Umgebungshelligkeit des Kraftfahrzeugs erfassen. Besonders bevorzugt umfassen die Signalgeber eine Vorfeldsensorik, die dazu eingerichtet ist, andere Verkehrsteilnehmer oder bestimmte Objekte, die sich im Vorfeld des Kraftfahrzeugs befinden, zu detektieren. Eine solche Vorfeldsensorik weist zum Beispiel eine Kamera auf. Diese Aufzählung ist nicht abschließend gemeint.

Das Steuergerät ist bevorzugt dazu eingerichtet, sowohl den Drehantrieb 18.7 als auch die Lichtemission des Lasers 14 zu steuern, wobei die Steuerung der Lichtemission des Lasers 14 in einer bevorzugten Ausgestaltung in Koordination mit dem Drehwinkel des Drehantriebs 18.7 und damit mit der Drehwinkelposition der lichtbrechenden inneren Grenzfläche 18.3 erfolgt.

Der transparente Festkörper besteht bevorzugt aus einer für das Laserlicht transparenten, rotierenden Walze. Die Walze ist aus zwei unterschiedlichen optischen Materialien zusammengesetzt. Ein einfallender Lichtstrahl wird an der inneren Grenzfläche 18.3 zwischen den beiden Materialien gebrochen und je nach Position (Rotationswinkel) der Walze unterschiedlich stark abgelenkt. Durch die gekrümmte Oberfläche 18.4 wirkt die Walze wie eine Linse und kann zur Fokussierung des Laserlichts verwendet werden.

Im Folgenden wird kurz die Funktion der Anordnung beschrieben. Das bevorzugt blaue Licht des Lasers 14 wird von dem Umlenkelement 18 auf das Leuchtmittel 16 und insbesondere bevorzugt auf einen von der Stellung der inneren Grenzfläche 18.3 abhängigen Teilbereich 16.1 des Leuchtmittels 16 fokussiert. Das Leuchtmittel besteht zum Beispiel aus Phosphor oder einer Phosphorverbindung. Der transparente Festkörper besteht aus einer rotierenden Walze, die zum Beispiel die Form eines Zylinders hat. Die Walze besteht aus zwei Hälften, die aus für das Laserlicht transparenten Materialien mit unterschiedlichen Brechungsindizes hergestellt sind. Die Drehachse 18.6 der Walze liegt bevorzugt in der Grenzfläche 18.3 zwischen den Materialien. Die gekrümmte Außenfläche der Walze wirkt wie eine Linse, die bei entsprechender Wahl der Oberflächenform (z.B. dem Radius im Fall eines Zylinders) und der Brechungsindizes der beiden Teilvolumina den Laserstrahl auf das Leuchtmittel 16 fokussiert. Im Fall einer zylindrischen Walze ist die Linse eine reine Zylinderlinse.

Für die drehwinkelabhängig lichtrichtende Funktion der Walze und damit des Lichtumlenkelements ist die bevorzugt plane innere Grenzfläche 18.3 zwischen den zwei Teilvolumina 18.1, 18.2 wesentlich. Das einfallende Licht 22 des Lasers wird an dieser Grenzfläche zwischen den zwei Teilvolumina gebrochen. Der Ablenkungswinkel hängt nach dem allgemein bekannten Brechungsgesetz vom Einfallswinkel ab und kann durch Drehung der Walze und damit der lichtbrechenden inneren Grenzfläche 18.3 um die Drehachse 18.6 verändert werden.

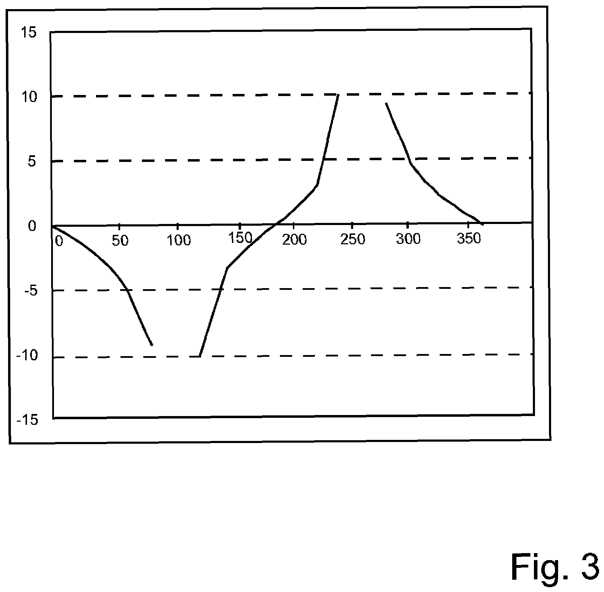

Figur 3 zeigt die Ablenkung des Laserstrahls als Funktion des Drehwinkels in Grad für eine Ausgestaltung eines erfindungsgemäßen Lichtumlenkelements 18. Die Darstellung wurde durch eine mit dem Raytracing Programm ZEMAX durchgeführte Simulation erhalten. Als transparenter Festkörper diente dabei eine kugelförmige Walze mit einem Radius von 15 mm, die durch eine plane Grenzfläche in zwei Hälften als Teilvolumina geteilt ist, wobei die eine Hälfte eine Brechungsindex von 1,4 und die andere Hälfte einen Brechungsindex von 1,6 aufweist.

Die Figur 3 zeigt insbesondere die Position eines Laserspots auf einem 10 mm von der Walze entfernten Schirm in mm. Bei Rotationswinkeln von 0 und 180 Grad fällt das Licht senkrecht auf die Grenzfläche zwischen den Teilvolumina ein, so dass der Strahl dort nicht abgelenkt wird. Die Ablenkung bei Rotationswinkeln in der Umgebung von 0 bzw. von 180 Grad ist relativ klein, da hier der Strahl nahezu senkrecht auf die innere Grenzfläche auffällt. Als Rotationswinkel wird dabei der Winkel zwischen der Flächennormalen der lichtbrechenden Fläche und dem einfallenden Laserstrahl betrachtet.

Bei einer Lage der Drehachse, die der Lage der Drehachse des transparenten Festkörpers in der Fig. 1 entspricht (parallel zur z-Achse), wandert der von der Kugel gebündelte Laserstrahl dann in der x-y-Ebene hin und her. Der vom Laserstrahl erzeugte Lichtfleck wandert damit bei einer vollständigen Umdrehung zunächst zu der einen Seite, die in der Figur 3 durch negative Ordinatenwerte gekennzeichnet ist, dann zurück zur Ausgangslage, dann weiter zu der anderen Seite, die durch positive Ordinatenwerte gekennzeichnet ist, und wieder zurück zur Ausgangslage.

Bei einer periodischen Drehung ergibt sich dadurch eine periodische Beleuchtung einzelner Teilbereiche 16.1 des Leuchtmittels, bei der die Oberfläche des Leuchtmittels abtastend beleuchtet wird. Dabei wird vorausgesetzt, dass der transparente Festkörper zu einem beliebigen Zeitpunkt immer nur einen Teilbereich des Leuchtmittels mit dem abgelenkten Laserlicht beleuchtet. Es ist daher bevorzugt, dass der vom Laser auf dem Leuchtmittel erzeugte Lichtfleck, der dem Teilbereich 16.1 entspricht, kleiner als die Fläche des Leuchtmittels ist.

Als Folge wird zu dem genannten Zeitpunkt auch nur der jeweils beleuchtete Teilbereich 16.1 zum Mitleuchten angeregt, so dass auch nur von diesem mitleuchtenden Teilbereich 16.1 weißes Mischlicht aus Fluoreszenzlicht und Laserlicht ausgeht. Dieser mitleuchtende Teilbereich 16.1 wandert daher periodisch auf dem Leuchtmittel 16 hin und her, so dass von dem Leuchtmittel 16 ausgehendes weißes Licht auch die Lichteintrittsfläche der Projektionsoptik 20 aus periodisch wechselnden Richtungen beleuchtet. Im Ergebnis führt dies dazu, dass auch das von der Projektionsoptik 20 ausgehende Licht periodisch in verschiedene Raumrichtungen gerichtet wird, wobei sich der Strahl kontinuierlich bewegt.

Zu einem beliebigen Zeitpunkt erzeugt der Scheinwerfer damit immer nur einen Teil der gewünschten Lichtverteilung. Der für die Erzeugung der gesamten gewünschten Lichtverteilung vor dem Scheinwerfer auszuleuchtende Raumwinkel wird dann durch den sich bewegenden Strahl jeweils immer nur zu einem Teil ausgeleuchtet, wobei jeder Punkt der gewünschten Lichtverteilung wenigstens einmal pro Umdrehung des transparenten Festkörpers durch den kontinuierlich wandernden Strahl kurzzeitig beleuchtet wird. In der Figur 1 ist dies ein Fokuspunkt 32 auf einem Schirm 34.

Bei einer hinreichend hohen Drehfrequenz des transparenten Festkörper, die dazu bevorzugt höher als 100 Hz ist, nimmt der menschliche Sehsinn die schnelle Bewegung des Lichtstrahls nicht wahr und registriert nur eine zeitlich gemittelte mittlere Helligkeit der gewünschten Lichtverteilung.

Betrachtet man erneut die Figur 3, so fällt insbesondere die Nichtlinearität der dort dargestellten Abhängigkeit der Ablenkung des Lichtstrahls vom Drehwinkel des transparenten Festkörpers, beziehungsweise von dem Winkel zwischen der inneren lichtbrechenden Fläche 18.3 und dem einfallenden Laserstrahl auf.

Entfernt man sich von den Drehwinkelwerten, bei denen keine Ablenkung stattfindet, steigt die Ablenkung stark nichtlinear an. Die Ursache für die Nichtlinearität ist die Nichtlinearität der Sinusfunktion im Brechungsgesetz. Die Nichtlinearität ist dabei dadurch gegeben, dass die auf Rotationswinkeländerungen normierte Ablenkung mit zunehmendem Winkelabstand von diesen Werten größer wird, was sich in der Figur 3 durch den mit zunehmendem Winkelabstand von diesen Werten steiler werdenden Kurvenverlauf abbildet.

Die Drehwinkelposition, bei der keine Ablenkung stattfindet, liegt bei der Ausgestaltung, die in der Figur 1 dargestellt ist, in der Fahrbahnmitte. Die Auslenkung des Lichtstrahls erfolgt periodisch zu den Seiten. Bei einem mit einer konstanten Winkelgeschwindigkeit rotierenden Festkörper bedeutet dies in Verbindung mit der genannten Nichtlinearität, dass sich der kontinuierlich wandernde Lichtstrahl in der Nähe der Fahrbahnmitte langsamer bewegt als weiter außen. Dies führt zu dem erwünschten und damit vorteilhaften Effekt, dass die Fahrbahnmitte im Vergleich zu weiter außen liegenden Bereichen der Lichtverteilung im zeitlichen Mittel mehr Licht erhält und damit heller ausgeleuchtet wird. Mit anderen Worten: Das nichtlineare Verhalten führt zu dem Vorteil, dass im Zentrum der Strahlbewegung im Mittel die höchste Intensität erzielt wird.

Bei Rotationswinkeln um 90 und 270 Grad zur Flächennormalen fällt das Licht streifend flach auf die lichtbrechende Grenzfläche ein. Dies führt dazu, dass dieses Licht dort nicht gebrochen, wird sondern dass dieses Licht entweder total reflektiert wird oder dass starke Reflexionsverluste und Aberrationen entstehen. Eine bevorzugte Ausgestaltung sieht vor, dass der Laser in diesen Winkelbereichen gedimmt oder ausgeschaltet wird. Bevorzugt ist auch, dass der Drehwinkelbereich des transparenten Festkörpers, über den der Laser ausgeschaltet wird, kleiner als +/- 20 Grad um die besagten Winkel ist. Der Laser kann dann immer noch bis zu etwa 80% der Drehwinkelspanne / Zeit eingeschaltet sein, so dass sich in der Summe noch eine große Beleuchtungsstärke ergibt.

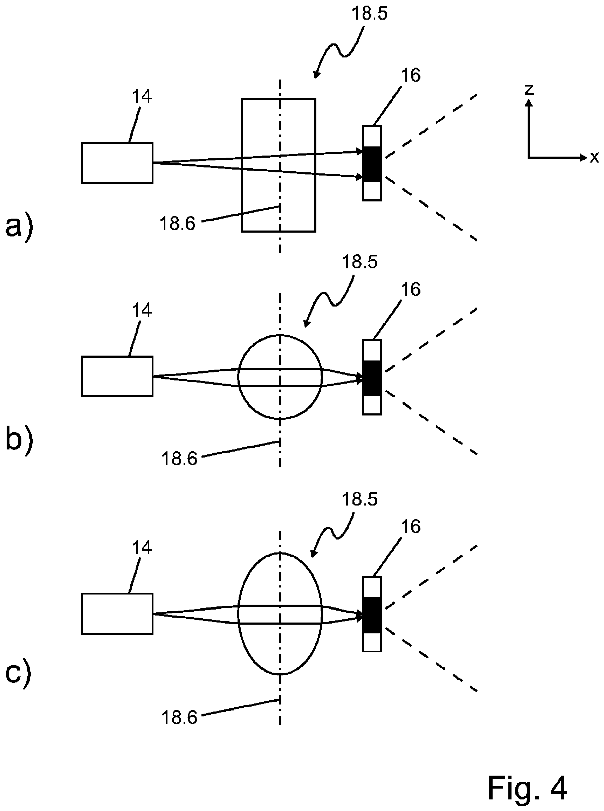

Die Figur 4 zeigt Ausgestaltungen, die sich in Form des jeweils rotierenden transparenten Festkörpers unterscheiden. Die Blickperspektive entspricht dabei jeweils der Blickperspektive der Figur 2. Es handelt sich also jeweils um eine Seitenansicht auf eine parallel zur x-z-Ebene liegende Ebene, in welcher die Drehachse des transparenten Festkörpers liegt. Diese Drehachse liegt im Übrigen in sämtlichen hier vorgestellten Ausgestaltungen bevorzugt in der ebenen lichtbrechenden Grenzfläche zwischen den zwei Teilvolumina des transparenten Festkörpers. In der Figur 4 liegt die Drehachse jeweils in der Zeichnungsebene, so dass die periodische Ablenkung senkrecht zur Zeichnungsebene erfolgt.

Die Figur 4a zeigt einen nicht erfindungsgemäßen walzenförmigen transparenten Festkörper 18.5, der in der x-y-Ebene den in der Figur 1 gezeigten kreisrunden Querschnitt besitzt. Eine solche Geometrie stellt eine Zylinderlinse dar. Sie bündelt das Licht nur in einer zur Zeichnungsebene senkrechten Richtung. Mit dieser Linse ergibt sich eine streifenförmige Beleuchtung des Leuchtmittels und ein leuchtender Streifen im Vorfeld des Scheinwerfers, der periodisch nach rechts und links und umgekehrt bewegt wird.

Die Figur 4b zeigt einen kugelförmigen transparenten Festkörper 18.5. Eine solche Geometrie erlaubt es, das Licht in zwei Raumrichtungen zu fokussieren. Es ergibt sich ein eher kreisförmiger Lichtverteilungsteilbereich, der bei der Rotation des transparenten Festkörpers periodisch von rechts nach links und umgekehrt bewegt wird.

Die Figur 4c veranschaulicht ein Ausführungsbeispiel mit einem als Freiformkörper ausgestalteten transparenten Festkörper 18.5. Eine solche Freiformfläche erlaubt eine fast beliebige Formung des Laserstrahls durch in zwei Raumrichtungen unterschiedliche Fokussierung.

Eine weitere bevorzugte Ausgestaltung zeichnet sich dadurch aus, dass die zwischen den beiden Teilvolumina des transparenten Festkörpers liegende lichtbrechende Grenzfläche als Freiformfläche ausgestaltet ist. Mit einer solchen Ausgestaltung kann zum Beispiel die Abhängigkeit der Fokusposition des durch den transparenten Festkörper fokussierten Laserstrahl von der Drehwinkelposition des transparenten Festkörpers verändert und insbesondere verringert werden.

Bei allen Ausführungsbeispielen könnte das Lichtumlenkelement auch so angeordnet sein, dass seine Rotationsachse 18.6 etwa parallel zur Y-Achse ausgerichtet ist.

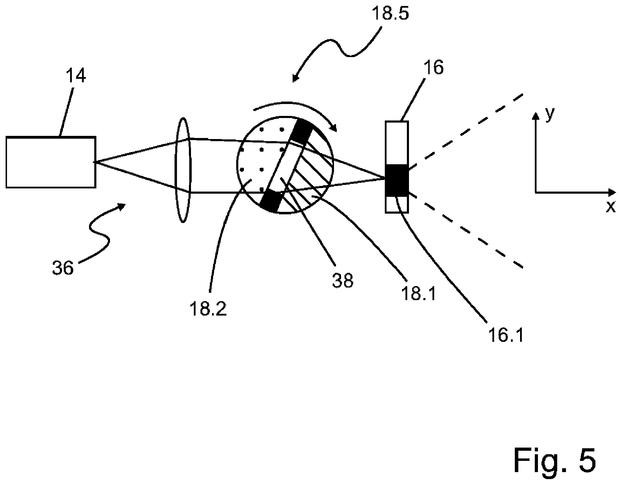

Die Figur 5 zeigt eine Ausgestaltung, die zwei Unterscheide zu den bis hier beschriebenen Ausgestaltungen aufweist. Beide Unterschiede, beziehungsweise die daraus jeweils resultierenden Ausgestaltungen, können auch unabhängig voneinander verwirklicht werden. Jeder der beiden Unterschiede kann mit jeder anderen der in dieser Anmeldung vorgestellten Ausgestaltungen kombiniert werden. Dies gilt auch für die Kombination der beiden Unterschiede miteinander.

Ein erster Unterschied besteht darin, dass zwischen dem Laser 14 und dem transparenten Festkörper 18.5 eine Strahlformungsoptik 36 angeordnet ist. Bei der Strahlformungsoptik handelt es sich bevorzugt um eine Linse, die den Laserstrahl 22 so umformt, dass er beim Durchtritt durch den rotierenden transparenten Festkörper 18.5 in geeigneter Weise auf einen Teilbereich 16.1 des Leuchtmittels 16 fokussiert wird.

Ein zweiter Unterscheid besteht darin, dass sich die beiden Teilvolumina 18.1 und 18.2 des transparenten Festkörpers 18.5 nicht flächig berühren, sondern dass sich zwischen ihnen ein Luftspalt 38 befindet. Ein solcher Luftspalt hat den Vorteil, das er die Herstellung des zwei Teilvolumina mit unterschiedlicher Brechzahl aufweisenden transparenten Festkörpers 18.5 vereinfacht, weil in dieser Anordnung zwischen den Teilvolumina 18.1, 18.2 auftretende mechanische Spannungen, die zum Beispiel durch Temperatureinflüsse hervorgerufen werden, weniger kritisch sind als bei einem flächigen Zusammenhalt beider Teilvolumina. Eine solche Ausgestaltung weist damit mehr als eine lichtbrechende Grenzfläche 18.3 zwischen den beiden Teilvolumina mit unterschiedlichen Brechungsindizes auf.

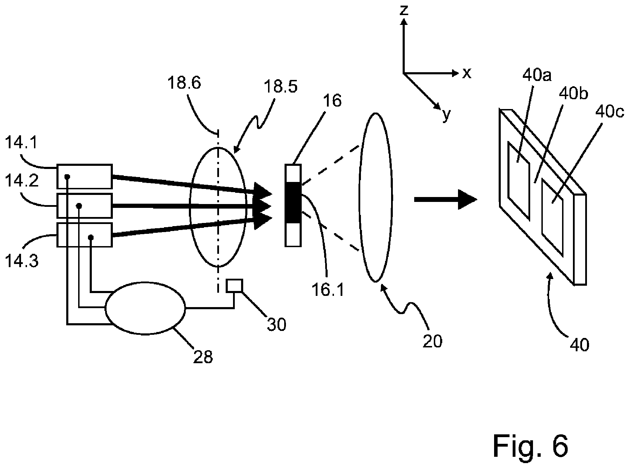

Die Figur 6 zeigt ein Ausführungsbeispiel, bei dem mehrere Laserlichtquellen 14.1, 14.2, 14.3 längs der z-Richtung übereinander angeordnet sind. Jeder Laser erzeugt damit in der Lichtverteilung, die sich im Vorfeld des Scheinwerfers einstellt, eine horizontale Lichtzeile, die im zeitlichen Mittel hell erscheint, wobei sich die helle Zeile auch hier durch das schnelle Hin- und Herwandern eines Lichtspots in der Horizontalen ergibt. In der dargestellten Ausgestaltung sind n = 3 Laser vertikal übereinander so angeordnet, dass sich die von ihnen generierten Lichtzeilen in vertikaler Richtung überlappen oder zumindest aneinander angrenzen, so dass die insgesamt resultierende Lichtverteilung keine dunklen Streifen aufweist. Es versteht sich, dass die Zahl n auch vom Wert 3 abweichen kann. Bevorzugt ist n eine Zahl von 2 bis 10.

In jeder Zeile kann ein bestimmter Winkelbereich in der x-y-Ebene abgedunkelt werden, indem die Lichtleistung des Lasers, der diese Lichtzeile erzeugt, genau dann verringert wird, wenn der in der Horizontalen hin und hergehende Lichtspot dieses Lasers den bestimmten Winkelbereich überstreicht. Die Lichtleistung des betreffenden Lasers oder der im Fall größerer abzudunkelnder Bereiche mehreren betreffenden Laser wird dazu von dem Steuergerät 28 (vergleiche Figur 2) phasensynchron zur Drehposition des transparenten Festkörpers 18.5 gesteuert.

Mit dieser Anordnung kann ein sogenanntes adaptives Fernlicht erzeugt werden bei dem das Licht in einzelnen horizontalen Winkelbereichen in einer oder mehreren Zeilen ausgeschaltet werden kann, um zum Beispiel entgegenkommende Fahrzeuge nicht zu blenden oder um eine Eigenblendung durch stark reflektierende Verkehrsschilder zu verhindern. In den anderen Bereichen wird das Licht nicht abgedunkelt, um die Straße möglichst gut auszuleuchten. Fig. 6 zeigt schematisch eine solche Lichtverteilung 40 mit zwei hellen Seitenbereichen 40a, 40c und einem abgedunkelten mittleren Bereich 40b.

Bei einer nicht erfindungsgemäßen Ausführung mit mehreren Lasern ist es auch denkbar, dass die Laser verschiedenfarbig sind (z.B. RGB) und zusammen bei genauer Überlagerung weißes Licht ergeben, so dass das Leuchtmittel 16 entfallen kann.

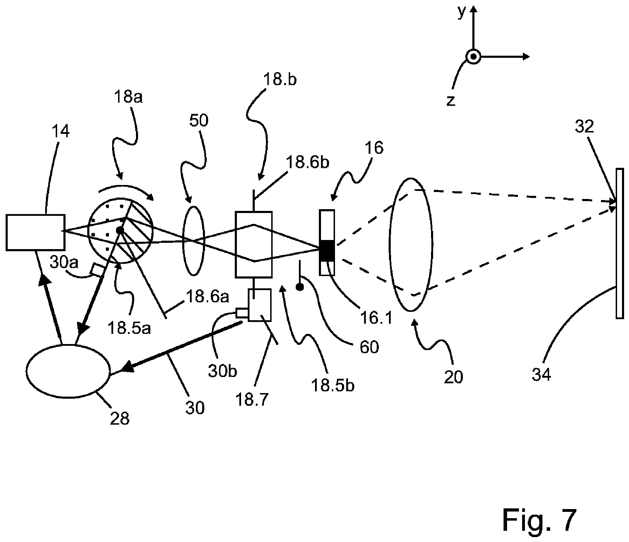

Die Figur 7 zeigt ein weiteres Ausführungsbeispiel, bei dem zwei Lichtumlenkelemente 18a, 18b, die jeweils einen rotierbaren transparenten Festkörper 18.5a, 18.5b der bis hierhin beschriebenen Art aufweisen, im Lichtweg hintereinander angeordnet sind.

Ein solches Ausführungsbeispiel erweitert den abtastend beleuchtbaren Bereich auf zwei Abtastrichtungen. In einer Ausgestaltung dieses Ausführungsbeispiels werden die zwei rotierbaren transparenten Festkörper mit um 90 ° gegeneinander verkippten Rotationsachsen 18.6a, 18.6b angeordnet. Bevorzugt ist auch, dass die rotierbaren transparenten Festkörper durch eine im Lichtweg zwischen ihnen liegende abbildende Optik 50 optisch miteinander gekoppelt sind, die die Verteilung von Walze 18a auf Walze 18b übertragt. Unter einer optischen Kopplung ist dabei zu verstehen, dass von dem im Lichtweg ersten transparenten Festkörper 18.5a ausgehendes Licht von der abbildenden Optik 50 auf den im Lichtweg zweiten transparenten Festkörper 18.5b gerichtet wird.

Diese abbildende Optik 50 besteht bevorzugt aus einem oder mehreren optischen Elementen.

Jeder der beiden rotierbaren transparenten Festkörper wird bevorzugt von einem eigenen Elektromotor 18.7 angetrieben, der nur diesen rotierbaren Festköper antreibt. Die Rotationsgeschwindigkeit wird zum Beispiel von einem Steuergerät 28, wie es in der Figur 2 dargestellt ist, gesteuert.

Dabei ist bevorzugt, dass ein Drehwinkelsensor den Drehwinkel eines rotierbaren transparenten Festkörpers erfasst und als Eingangssignal an das Steuergerät übergibt 28. Der Drehwinkelsensor kann an dabei so angeordnet sein, dass er den Drehwinkel des ersten rotierbaren transparenten Festkörpers oder des zweiten rotierbaren transparenten Festkörpers erfasst. Besonders bevorzugt ist eine Ausgestaltung, bei der ein erster Drehwinkelsensor 30a den Drehwinkel des ersten rotierbaren transparenten Festkörpers 18.5a und ein zweiter Drehwinkelsensor 30b den Drehwinkel des zweiten rotierbaren transparenten Festkörpers 18.5b erfasst. Im Lichtweg hinter dem Leuchtmittel 16 kann eine das Lichtbündel formende Blende 60, die auch beweglich ausgestaltet sein kann, angeordnet sein. Die Blende ist bevorzugt zwischen dem Leuchtmittel 16 und der Linse 20 in der Nähe der Brennzone der Linse 20 angeordnet. Die Blende 60 wird, sofern sie beweglich ist, bevorzugt von Steuergerät 28 gesteuert, um zum Beispiel zwischen einer Abblendlichtverteilung und einer Fernlichtverteilung umzuschalten.

In einer weiteren Ausgestaltung ist vorgesehen, dass an Stelle des ersten rotierbaren transparenten Festkörpers 18.5a oder an Stelle des zweiten rotierbaren transparenten Festkörpers 18.5b ein nach einem anderen Prinzip arbeitendes Lichtumlenkelement verwendet wird, wobei dieses Lichtumlenkelement ein MEMS Mikrospiegelfeld (MEMS = Micro Electro Mechanical System), ein Galvanometer Scanner, ein rotierender Propeller, ein elektrooptischer Scanner oder ein rotierender Polygonscanner ist.

Die in dieser Anmeldung als Bestandteile eines Scheinwerfers beschriebenen Lichtumlenkelemente können auch in anderen Anwendungen verwendet werden, zum Beispiel in Laserprinter (siehe z.B. JPH03228011A) oder in Laser Radaren, in graphischen Anzeigevorrichtungen, Bildgebungssystemen und anderen Vorrichtungen (siehe US 2004/0036934 A1).

Aus Sicht der Anmelderin besitzt die Anwendung von in Anspruch 1 definierten Lichtumlenkelemente in Scheinwerfern von Kraftfahrzeugen eine eigene erfinderische Qualität. Eine solche Anwendung ergibt zum Beispiel einen Scheinwerfer, mit einem Laser, einem Leuchtmittel und einem in einem Lichtweg zwischen dem Laser und dem Leuchtmittel angeordneten Lichtumlenkelement, das dazu eingerichtet und angeordnet ist, Licht des Lasers periodisch auf verschiedene Bereiche des Leuchtmittels zu richten, welches Leuchtmittel auf einfallendes Laserlicht mit einer Emission von Fluoreszenzlicht reagiert, und mit einer Projektionsoptik, die dazu eingerichtet und angeordnet ist, vom Leuchtmittel ausgehendes Licht in ein vor dem Scheinwerfer liegendes Vorfeld zu richten.

## Patentansprüche

1. Scheinwerfer (10) für ein Kraftfahrzeug, mit einem Lichtumlenkelement (18), das dazu eingerichtet und angeordnet ist, Licht mindestens eines Lasers (14) periodisch in verschiedene Raumrichtungen auf einen Teilbereich (16.1) eines Leuchtmittels (16) zu richten, der kleiner als die Fläche des Leuchtmittels ist, **dadurch gekennzeichnet, dass** das Lichtumlenkelement einen drehbar im Scheinwerfer gelagerten transparenten Festkörper (18.5) und einen zur Drehung des transparenten Festkörpers eingerichteten Elektromotor aufweist, der von einem Steuergerät (28) gesteuert wird, das die Lichtleistung des Lasers (14) phasensynchron zur Drehposition des transparenten Festkörpers (18.5) steuert, wobei der transparente Festkörper wenigstens zwei Teilvolumina (18.1, 18.2) mit unterschiedlicher Brechzahl aufweist, die durch wenigstens eine lichtbrechende Grenzfläche (18.3) voneinander getrennt sind, und wobei der transparente Festkörper dazu eingerichtet ist, das Laserlicht in zwei Raumrichtungen zu fokussieren, und wobei der transparente Festkörper so angeordnet ist, dass sich die lichtbrechende Grenzfläche (18.3) bei der Drehung des transparenten Festkörpers in dem Lichtweg befindet und dass sich die Drehwinkelposition der lichtbrechenden Grenzfläche (18.3) relativ zu dem einfallenden Laserlicht 22 bei einer Drehung des Festkörpers verändert.

2. Scheinwerfer (10) nach Anspruch 1, **dadurch gekennzeichnet, dass** der Scheinwerfer mehrere übereinander angeordnete Laser aufweist, von denen jeder dazu eingerichtet ist, in Verbindung mit den Merkmalen des Anspruchs 1 eine horizontale Lichtzeile im Vorfeld des Scheinwerfers zu erzeugen, wobei die erzeugten Lichtzeilen in vertikaler Richtung aneinander angrenzen oder sich überlappen.

3. Scheinwerfer (10) nach einem der vorhergehenden Ansprüche, **dadurch gekennzeichnet, dass** das Lichtumlenkelement eine für das Laserlicht transparente rotierbare Walze aufweist.

4. Scheinwerfer (10) nach Anspruch 3, **dadurch gekennzeichnet, dass** der transparente Festkörper eine Walze ist.

5. Scheinwerfer (10) nach Anspruch 3 oder 4, **dadurch gekennzeichnet, dass** die Oberfläche der Walze als fokussierende Linse ausgestaltet ist.

6. Scheinwerfer (10) nach Anspruch einem der Ansprüche 3 bis 5, **dadurch gekennzeichnet, dass** die Walze eine Kugelform aufweist.

7. Scheinwerfer (10) nach einem der Ansprüche 3 bis 5, **dadurch gekennzeichnet, dass** die Walze eine Freiform aufweist.

8. Scheinwerfer (10) nach einem der vorhergehenden Ansprüche, **dadurch gekennzeichnet, dass** die lichtbrechende innere Grenzfläche (18.3) eine Grenzfläche ist, welche beide Teilvolumina begrenzt, so dass sich die beiden Teilvolumina (18.1, 18.2) in der Grenzfläche (18.3) berühren.

9. Scheinwerfer (10) nach einem der Ansprüche 1 bis 6, **dadurch gekennzeichnet, dass** sich zwischen beiden Teilvolumina (18.1, 18.2) ein Luftspalt oder ein mit Material einer Brechzahl n3 ungleich n2 ungleich n1 gefüllter Spalt zwischen den beiden Teilvolumina befindet.

10. Scheinwerfer (10) nach einem der vorhergehenden Ansprüche, **dadurch gekennzeichnet, dass** die innere lichtbrechende Grenzfläche (18.3) eine ebene Grenzfläche ist.

11. Scheinwerfer (1) nach Anspruch 9, **dadurch gekennzeichnet, dass** die Drehachse (18.6) in der inneren lichtbrechenden Grenzfläche (18.3) liegt.

12. Scheinwerfer (10) nach einem Ansprüche 1 bis 8, **dadurch gekennzeichnet, dass** die innere lichtbrechende Grenzfläche eine Freiformfläche ist.

## Claims

1. Headlamp (10) of a motor vehicle, having a light deflecting element (18) which is set up and arranged to direct light from at least one laser (14) periodically in different spatial directions onto a partial region (16.1) of a illumination means (16) which is smaller than the surface area of the illumination means, **characterized in that** the light deflecting element comprises a transparent solid body (18.5) which is mounted rotatably in the headlamp and an electric motor arranged to rotate the transparent solid body and controlled by a control unit (28) which controls the light output of the laser (14) in phase synchronism with the rotational position of the transparent solid body (18.5), said transparent solid comprising at least two partial volumes (18.1, 18.2) of different refractive indices separated by at least one boundary surface (18.3), said transparent solid being adapted to focus said laser light in two spatial directions, and said transparent solid being arranged so that said boundary surface interface (18.3) is located in the light path during rotation of the transparent solid body, and **in that** the rotational angle position of the refracting boundary surface (18.3) changes relative to the incident laser light 22 during rotation of the solid body.

2. Headlamp (10) according to claim 1, **characterized in that** the Headlamp comprises a plurality of lasers arranged one above the other, each of which is adapted to generate, in connection with the features of claim 1, a horizontal line of light in front of the headlamp the generated lines of light adjoining or overlapping one another in the vertical direction.

3. Headlamp (10) according to one of the preceding claims, **characterized in that** the light deflecting element comprises a rotatable roll transparent to the laser light.

4. Headlamp (10) according to claim 3, **characterized in that** the transparent solid is a roll.

5. Headlamp (10) according to claim 3 or 4, **characterized in that** the surface of the roll is designed as a focusing lens.

6. Headlamp (10) according to claim one of claims 3 to 5, **characterized in that** the roll has a spherical shape.

7. Headlamp (10) according to one of claims 3 to 5, **characterized in that** the roll has a free form.

8. Headlamp (10) according to one of the preceding claims, **characterized in that** the refracting inner boundary surface (18.3) is a boundary surface which delimits both partial volumes so that the two partial volumes (18.1, 18.2) touch each other in the boundary surface (18.3).

9. Headlamp (10) according to one of claims 1 to 6, **characterized in that** between the two partial volumes (18.1, 18.2) there is an air gap or a gap filled with material having a refractive index n3 not equal to n2 not equal to n1 between the two partial volumes.

10. Headlamp (10) according to one of the preceding claims, **characterized in that** the inner refracting boundary surface (18.3) is a planar boundary surface.

11. Headlamp (1) according to claim 9, **characterized in that** the axis of rotation (18.6) lies in the inner refracting boundary surface (18.3).

12. Headlamp (10) according to claims 1 to 8, **characterized in that** the inner refracting boundary surface is a free-form surface.

## Revendications

1. Projecteur (10) pour véhicule automobile, comprenant un élément de déviation de lumière (18) qui est configuré et disposé pour diriger la lumière d'au moins un laser (14) de manière périodique dans différentes directions spatiales, sur une région partielle (16.1) d'un moyen d'éclairage (16) qui est plus petite que la surface du moyen d'éclairage, **caractérisé en ce que** l'élément de déviation de lumière présente un corps solide transparent (18.5) logé de façon à pouvoir pivoter dans le projecteur et un moteur électrique conçu pour la rotation du corps solide transparent et commandé par un dispositif de commande (28) qui commande la puissance lumineuse du laser (14) en synchronisation de phase avec la position de rotation du corps solide transparent (18.5), le corps solide transparent comportant au moins deux volumes partiels (18.1, 18.2) ayant un indice de réfraction différent, lesquels sont séparés l'un de l'autre par au moins une interface de réfraction (18.3), et le corps solide transparent étant conçu pour focaliser la lumière laser dans deux directions spatiales, et le corps solide transparent étant disposé de telle sorte que l'interface de réfraction (18.3) se trouve dans le trajet de la lumière lors de la rotation du corps solide transparent, et que la position de rotation angulaire de l'interface de réfraction (18.3) varie par rapport à la lumière laser incidente (22) lors d'une rotation du corps solide.

2. Projecteur (10) selon la revendication 1, **caractérisé en ce que** le projecteur comporte plusieurs lasers superposés dont chacun est conçu pour produire, en liaison avec les caractéristiques de la revendication 1, une ligne de lumière horizontale dans le champ avant du projecteur, les lignes de lumière produites étant adjacentes entre elles ou se chevauchant en direction verticale.

3. Projecteur (10) selon l'une des revendications précédentes, **caractérisé en ce que** l'élément de déviation de lumière présente un rouleau rotatif transparent à la lumière laser.

4. Projecteur (10) selon la revendication 3, **caractérisé en ce que** le corps solide transparent est un rouleau.

5. Projecteur (10) selon la revendication 3 ou 4, **caractérisé en ce que** la surface du rouleau est réalisée sous la forme d'une lentille de focalisation.

6. Projecteur (10) selon l'une des revendications 3 à 5, **caractérisé en ce que** le rouleau a une forme sphérique.

7. Projecteur (10) selon l'une des revendications 3 à 5, **caractérisé en ce que** le rouleau a une forme libre.

8. Projecteur (10) selon l'une des revendications précédentes, **caractérisé en ce que** l'interface intérieure de réfraction (18.3) est une interface qui délimite les deux volumes partiels, de sorte que les deux volumes partiels (18.1, 18,2) se touchent dans l'interface (18.3) .

9. Projecteur (10) selon l'une des revendications 1 à 6, **caractérisé en ce qu'**entre les deux volumes partiels (18.1, 18.2) se trouve un entrefer ou une fente remplie de matériau d'un indice de réfraction n3 différent de n2 différent de n1 entre les deux volumes partiels.

10. Projecteur (10) selon l'une des revendications précédentes, **caractérisé en ce que** l'interface intérieure de réfraction (18.3) est une interface plane.

11. Projecteur (10) selon la revendication 9, **caractérisé en ce que** l'axe de rotation (18.6) se situe dans l'interface intérieure de réfraction (18.3).

12. Projecteur (10) selon l'une des revendications 1 à 8, **caractérisé en ce que** l'interface intérieure de réfraction est une surface de forme libre.
